# EUROPEAN PATENT APPLICATION

(11) **EP 1 484 805 A2**
(43) Date of publication of application: **08.12.2004**
(21) Application number: 04013177.3
(22) Date of filing: 03.06.2004
(51) Int. Cl.: H01L 51/20

(54) **Organic electroluminescence device and method for producing the same**

(30) Priority: 04.06.2003 JP 2003159172
(71) Applicant: Kabushiki Kaisha Toyota Jidoshokki, Kariya-shi, Aichi-ken (JP)
(72) Inventor: Yamaguchi, Takeshi, Kariya-shi Aichi-ken (JP); Naito, Hisashi, Kariya-shi Aichi-ken (JP); Nagara, Yoshiaki, Kariya-shi Aichi-ken (JP)
(74) Representative: Leson, Thomas Johannes Alois, Dipl.-Ing.

(57) **Abstract**

An organic electroluminescence device comprising a substrate, a first electrode, an organic electroluminescence layer and a second electrode laminated on the substrate in this order, and a passivation layer laminated on the outside of the second electrode. A film thickness t, which is a distance from a surface of the first electrode to the outer surface of the passivation layer in an area devoid of any foreign particle on a portion of the first electrode associated with the organic EL layer, is larger than the size of any foreign particle which is present on the first electrode.

## Description

The present invention relates to an organic electroluminescence device and a method for producing the same.

Organic electroluminescence devices (the term "electroluminescence" is hereinafter referred to as "EL") have brought attention as display devices for replacing liquid crystal displays and as thin type illumination devices. Organic EL devices in general are formed by forming a transparent electrode (anode) comprising indium tin oxide (ITO) on a glass substrate, forming an organic EL layer including an emitting layer on the transparent electrode and then laminating a cathode thereon. Light emitted from the emitting layer is extracted from the glass substrate side.

The organic EL devices have a disadvantage in that areas called dark spots or dark areas, which do not illuminate, may extend due to oxygen or moisture in the atmosphere unless they are used by shielding them from the external atmosphere, since they have low resistivity to oxygen and moisture. As a measure to shield organic EL layers from the external atmosphere, there is a method of forming passivation layer which covers the organic EL layer and exposed portions of the cathode after forming the cathode, for example in Japanese Laid-Open Patent Publication 8-111285.

Further, an extremely thin organic EL layer is often formed by evaporation. Accordingly, when a foreign particle (microparticle) adheres onto the transparent electrode, the organic EL layer and the second electrode layer and sealant layer (passivation layer) are not well formed so that this area makes the organic EL device defective. Therefore, cleaning of the substrates, onto which the ITO film is formed, before forming an organic EL layer is important.

Moreover, it is known in the art that the contamination of the substrate, on which transparent electrodes are formed, greatly effects performance of the organic EL devices. The determination of the contamination condition of a transparent electrode formed on the substrate by using the contact angle of water on the electrode surface to produce organic EL devices under conditions where contamination is low, has been proposed for example in Japanese Laid-Open Patent Publication 7-220873 and Japanese Patent 2845856.

Japanese Laid-Open Patent Publication 7-220873 discloses forming an organic EL layer on the surface of a transparent conductive film of a transparent conductive substrate for which a cleaning process has been performed to set the contact angle of water below 25 degrees. Japanese Patent 2845856 teaches setting a time between the completion of cleaning of the substrate on which electrodes are formed, and the start of film formation of the first layer, to be shorter than a time in which the contact angle of water of the electrode surface increases by 30 degrees as measured in vacuum from a value at the completion of the cleaning.

However, both of the above described publications determine the contamination condition of the electrode surface by the contact angle of water. It is time consuming to measure the contact angle of water on the entire surface of the electrode, and also it is not realistic since steps such as removing water are necessary when the organic EL layer is formed on the substrate on which the contact angle is measured. Measurement of the contact angle of water is therefore performed in the areas where the organic EL layer will not be formed or on a dummy substrate on which electrode is formed. Accordingly, the contamination condition is not measured with respect to the surfaces on which organic EL layer is actually formed. Thus, the organic EL layers are formed with contamination where substrates with electrodes having local contamination are used, so that defective products are still produced.

Further, it is difficult to detect adhesion of microparticles by the method of detecting contamination on the electrode surface by the contact angle of water. Therefore, such a method is less effective in suppressing decrease in product life and generation of display defects due to the presence of microparticles.

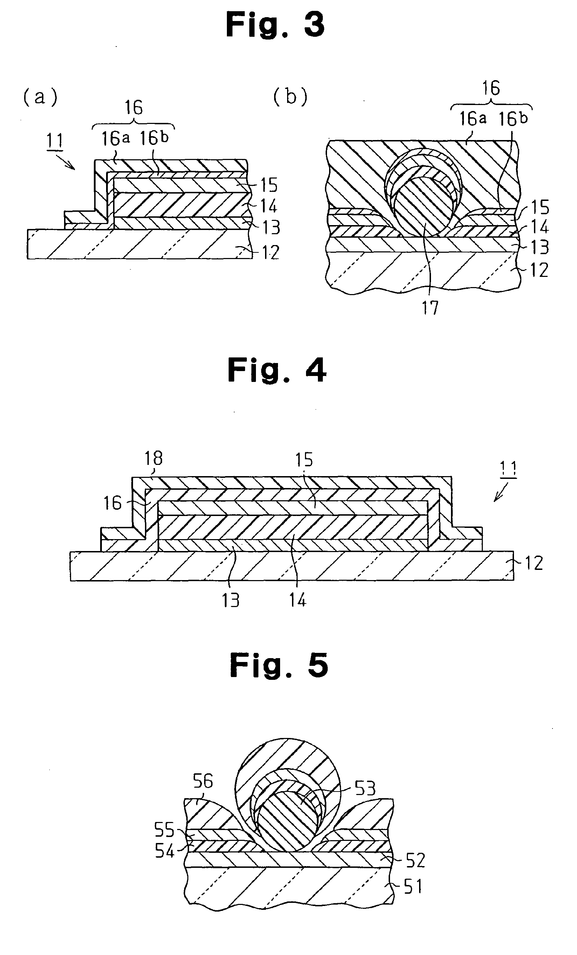

As shown in FIG. 5, when an organic EL layer 54 and a cathode 55 are formed by evaporation in the state where a foreign particle (microparticle) 53 is present on a transparent electrode (ITO electrode) 52 formed on a substrate 51, the oranic EL layer 54 and the cathode 55 are not formed in the areas shaded by the foreign particle 53. Further, the materials of the organic EL layer 54, cathode 55 and the passivation layer 56 can adhere to the foreign particle 53 to extraordinally extend from the nucleus of the foreign particle 53. If the foreign particle 53 is large, the passivation layer 56 cannot completely fill the spaces, even if the passivation layer 56 is formed by evaporation with a thickness larger by an order of magnitude compared to the organic EL layer 54 and the cathode 55 after forming the cathode 55. Moisture or oxygen reaches the organic EL layer from the points where the foreign particle 53 is present, so that dark spots are formed.

The present invention is devised in view of the problems inherent in the conventional art. An object of the invention is to provide an organic EL device having longer lifetime and less defects compared to the case where a foreign particle is present and is larger than the film thickness from the electrode surface to the outer surface of the passivation layer. A further object of the invention is to provide a method for producing organic EL devices, which enables production of the above described organic EL devices with good yield.

In order to achieve these objects, the present invention provides an organic electroluminescence device including a substrate, a first electrode, an organic electroluminescence layer and a second electrode laminated on the substrate in this order. Further, a passivation layer is laminated on the outside of the second electrode. A thickness t, which is the distance from a surface of the first electrode to the outer surface of the passivation layer in an area devoid of a foreign particle on a portion of the first electrode associated with the organic EL layer, is larger than the size of any foreign particle present on the first electrode.

The term "passivation layer" denotes a layer having a function to prevent permeation of at least moisture (vapor) and oxygen.

The invention, together with objects and advantages thereof, may best be understood by reference to the following description of the presently preferred embodiments together with the accompanying drawings in which:
FIG. 1 (a) is a cross sectional view schematically showing an organic EL device according to an embodiment of the invention, and FIGs. 1 (b) and 1 (c) are partial cross sectional views showing a foreign particle;
FIG. 2 is a flow chart showing process steps for manufacturing;
FIG. 3 (a) is a partial cross sectional view schematically showing an organic EL device according to another embodiment;
FIG. 3 (b) is a cross sectional view schematically showing a portion where the foreign particle is present;
FIG. 4 is a schematic cross sectional view of an organic EL device according to another embodiment; and
FIG. 5 is a schematic cross sectional view showing the effect of foreign particles in prior art.

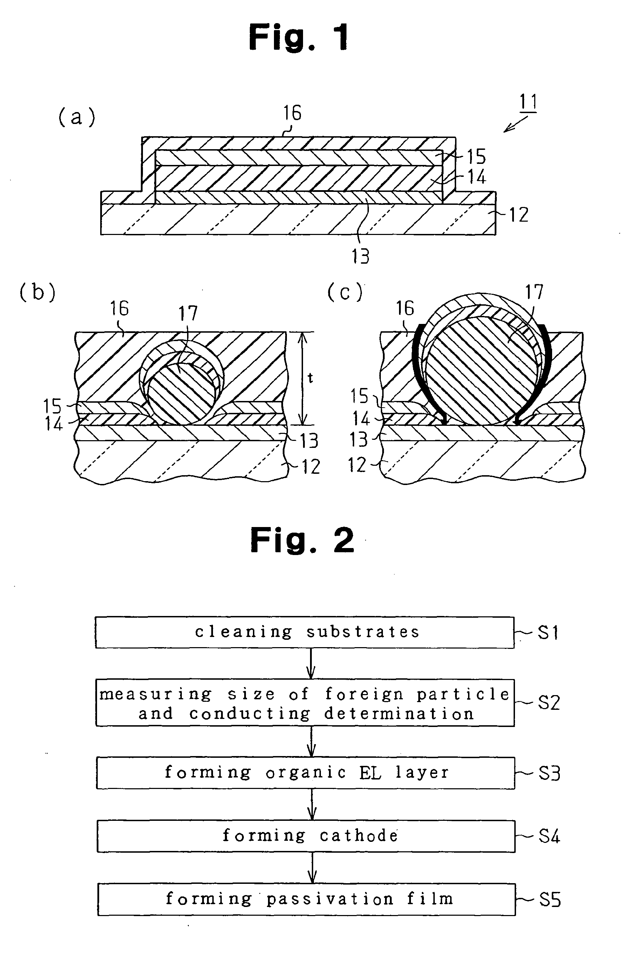

An embodiment of the invention, in which the present invention is applied for use in organic EL devices used for backlighting, is described below by referring to FIGs. 1 to 3.

As shown in FIG. 1 (a) , an organic electroluminescence device (organic EL device) 11 is formed with a first electrode (anode) 13 on the surface of a glass substrate 12, an organic electroluminescence layer (organic EL layer) 14 and a second electrode (cathode) 15 laminated in this order. The passivation layer 16 covers the areas except the planes where the first electrode 13, the organic EL layer 14 and the second electrode 15 adjoin each other. Namely, the organic EL device 11 has a construction in which the first electrode 13, the organic EL layer 14 and the second electrode 15 are laminated in this order onto the glass substrate 12 and the passivation layer 16 is laminated on the outer side of the second electrode 15. The organic EL device 11 forms a so-called bottom emission type organic EL device, in which light generated from the organic EL layer 14 is extracted (emitted) from the glass substrate 12 side.

The first electrode 13 is a transparent electrode formed from indium tin oxide (ITO) film. The term "transparent" denotes that visible light is permeable therethrough. The organic EL layer 14 has a structure corresponding to any known structures, for example, a three-layer structure having a hole injection layer, an emitting layer and an electron injection layer laminated in this order from the first electrode 13, or four-layer structure having a hole injection layer, a hole transport layer, an emitting layer and an electron transport layer. The second electrode 15 is formed from metal (for example aluminum).

The passivation layer 16 functions to prevent permeation of at least moisture (vapor) and oxygen, and is comprised of an applied layer formed from material which enables to form the passivation layer 16 by application. For example, polysilazane is used for the material of the passivation layer 16. Polysilazane is converted into silica at room temperature after being formed by application.

In the organic EL device 11, the thickness to a distance from the surface of the first electrode 13 to the outer surface of the passivation layer 16 in an area in which a foreign particle is not present on the first electrode 13, which is associated with the organic EL layer 14, is formed to be larger than the size of the foreign particle 17 which is present on the first electrode as shown in FIG. 1 (b) . The term "size of the foreign particle" denotes a maximum length of a projected image of the foreign particle 17 onto the surface of the first electrode 13. In this way, the lifetime of the product can be increased and defects can be decreased compared to cases where foreign particle 17 having a size larger than the thickness t from the surface of the first electrode 13 to the outer surface of the passivation layer 16 is present.

A method for producing the organic EL device 11 as described above is next described. The production of the organic EL device 11 is performed through the steps shown by the flowchart in FIG. 2.

A glass substrate 12, on which the first electrode 13 comprising ITO film is formed, is prepared. In step S1, cleaning of the glass substrate 12 and the first electrode 13 is performed. Organic substances and relatively large dust adhered to the first electrode 13 surface are removed in the substrate cleaning step. Ultraviolet (UV) cleaning and plasma treatment can further be performed to remove smaller dust particles and organic substances which are not removed by the cleaning.

In step S2, measurement of the foreign particle 17 size and determination is performed of whether the size of the foreign particle 17 is less than a predetermined value for the total thickness of the later laminated organic EL layer 14, second electrode 15 and passivation layer 16. The measurement of the foreign particle size is performed, by taking a photograph of the surface of the first electrode 13 on the glass substrate 12, for example through a window of a chamber in which the glass substrate 12 is contained, and by measuring the maximum length of a projection image of the foreign particle 17 onto the surface of the first electrode 13. Whether any foreign particle 17 is present having a size no less than the predetermined value is then determined. The process proceeds to step S3 to perform the production steps thereafter if there is no foreign particle 17 having a size larger than the predetermined value. The glass substrate 12 is returned to the cleaning process if there is any foreign particle 17 present having a size larger than the predetermined value.

The organic EL layer 14 is formed (deposited) in the organic EL layer forming process of the step S3. The organic EL layer 14 is formed, for example by evaporation and is formed by successively forming each layer which comprising the organic EL layer 14 by evaporation. The term "evaporated layer" used herein denotes a layer formed by methods for forming thin layers in a vacuum state or under reduced pressure, such as vacuum evaporation, sputtering, ion plating, ion beam, chemical vapor deposition, etc. The second electrode 15 is formed through a cathode forming step S4. The second electrode 15 is formed, for example by evaporation of aluminum. The passivation layer 16 is then formed in a passivation layer forming step S5.

The process steps are conducted in vacuum without being exposed to the atmosphere, from the plasma treatment, which is the latter half of the substrate cleaning step S1, through the cathode forming step S4. After completing the cathode forming step, an inert gas such as nitrogen gas is introduced into the chamber in which cathode forming was performed to resume the pressure within the chamber to atmospheric pressure. The glass substrate 12 is then transferred into a chamber of an application apparatus in a state with the nitrogen atmosphere. The passivation layer 16 is then formed through treatment of the application apparatus. A spin coating apparatus can be used for the apparatus, for example. An example of the application liquid is a solution dissolving polysilazane in a solvent which does not include a hydroxyl group and is insoluble to water (xylene, for example).

In this way, the production yield can be improved. Otherwise if the processes are completed through to the end with any large foreign particle 17 at least a portion thereof projecting from the passivation layer 16, such product would be determined as being defective during later product inspection. The method described above avoids any of such defect.

Since the size of foreign particles 17 on the surface of the first electrode 13 to which the organic EL layer 14 is to be formed is actually measured, the yield is further improved compared to cases where the detection and size measurement of foreign particles 17 are performed for only a portion of the surface of the first electrode 13.

The organic EL device 11 thus formed is next described in further detail.

The areas on which the first electrode 13, the organic EL layer 14 and the second electrode 15 are formed can be deteriorated in the presence of moisture or oxygen to generate dark spots or dark areas. However, the organic EL device 11 is covered by the passivation layer 16 except for the planes on which the first electrode 13, the organic EL layer 14 and the second electrode 15 adjoin each other. The permeation of moisture and oxygen in the outer atmosphere to the organic EL layer 14 is suppressed to retain longer life for the organic EL device 11 if the passivation layer 16 does not have any defects since the passivation layer 16 is formed from a material which prevents permeation of moisture and oxygen.

If the organic EL layer 14 is formed in a state where a foreign particle 17 is present on the first electrode 13, a gap can be formed in an area shaded by the foreign particle 17 between the foreign particle 17, and the organic EL layer 14 and the second electrode 15. However in the present invention, a passivation layer 16 is formed by application of a layer to fill in the gaps. When the size of the foreign particle 17 is larger than the thickness t between the surface of the first electrode 13 and the outer surface of the passivation layer 16 as shown in FIG. 1 (c) , the particle 17 together with the organic EL layer 14 and the second electrode 15 deposited thereon would project fromthe outer surface of the passivation layer 16. Accordingly, a passage which communicates the organic EL layer 14 to the external atmosphere of the organic EL device 11 (schematically shown by arrows in FIG. 1(c)) can be readily generated along the surface of the foreign particle 17 so that external moisture and oxygen can penetrate into the inside of the organic EL device 11 to reach the organic EL layer 14, thereby generating dark spots and dark areas.

On the other hand, the size of the foreign particles 17 is smaller than the thickenss t in the present invention even in cases where a foreign particle 17 maybe present. Accordingly, since any such foreign particle 17 cannot project from the outer surface of the passivation layer 16 as shown in FIG. 1(b), a function to prevent permeation of moisture and oxygen due to the passivation layer 16 can be retained.

It should be apparent to those skilled in the art that the present invention may be embodied in many other specific forms without departing from the spirit or scope of the invention. Particularly, it should be understood that the invention may be embodied in the following forms.

The passivation layer 16 can be formed of evaporated layers of silicon nitride or diamond-like-carbon in place of forming them by application. However, if the passivation layer is formed from the evaporated layer, the layer can not be formed in the areas shaded by the foreign particle 17, in the case where evaporation is performed by holding the substrate to strike the vaporized materials approximately vertically with respect to the glass substrate 12. In order to prevent such a case, deposition needs to be conducted by controlling the direction of the glass substrate 12 to provide the vaporized substance from various directions with respect to the glass substrate 12. For example, the glass substrate 12 can be tilted within a range of 360 degrees along a micro virtual semi-sphere having a center on a straight line passing through the vapor source and a point of the glass substrate 12. In this case, formation of the organic EL layer 14, the second electrode 15 and the passivation layer 16 can be performed continuously in vacuum.

The passivation layer can be formed from a plurality of layers instead of forming it from a single layer. The permeability of moisture and oxygen is low in layers formed by vapor deposition of silicon nitride, etc., compared to layers formed by application. However, position control of the glass substrate 12 during vapor deposition is complicated in the case where the layer is formed only from deposited layers. Accordingly, the function of preventing permeation of moisture and oxygen of the passivation layer 16 can be enhanced by combining an evaporated layer and an applied layer because advantages of both layers can be obtained. For example, the passivation layer 16 is formed from a double layered structure of an applied layer 16a and an evaporated layer 16b formed inside of the applied layer as shown in FIG. 3 (a) . In this case, since the evaporated layer 16b cannot fill in the gap between the foreign particle 17 and the organic EL layer 14 and the second electrode 15 since it is formed by holding the glass substrate at a constant position, as shown in FIG. 3(b). However, the function to prevent permeability of moisture and oxygen can be enhanced in the passivation layer 16 as a whole because the applied layer 16a fills in the gap.

Further, the applied layer 16a is formed in an inert gas atmosphere instead of a vacuum state. Accordingly, if the evaporated layer 16b is formed on the outside of the applied layer 16a, the production processes are complicated because the evaporated layer 16b is formed in vacuum after forming the applied layer 16a by reinstating the environment of the organic EL device 11 at atmospheric pressure after the second electrode 15 is formed. However, in structures formed with the evaporated layer 16b on the inner side of the applied layer 16a, the production process is simplified because the applied layer 16a can be formed by reinstating atmospheric pressure after continuously forming the organic EL layer 14, the second electrode 15 and the evaporated layer 16b in vacuum.

The passivation layer 16 can be formed to have a structure with the evaporated layer 16b on the outside of the applied layer 16a.

A metal layer can be provided as a layer of the passivation layer 16 having a plurality of layers. The metal layer needs to be provided in a condition where the first electrode 13 and the second electrode 15 will not be short-circuited. It is for example preferably provided on the outside of the passivation layer 16. It is unlikely that pin holes are generated, compared to a ceramic layer of the same thickness and has higher impact resistant to external force, to improve the performance of the passivation layer 16.

As shown in FIG. 4, the organic EL device 11 can be provided with a layer 18 adhered to the outside of the passivation layer 16. Since the thicknesses of the organic EL layer 14 and the second electrode 15 are less than 1µm and the passivation layer has a thickness of several micrometers, the organic EL device has low impact resistivity to external force and is liable to be destroyed or damaged if impacted. However, because the layer 18 is adhered to the outside of the passivation layer 16, the elements of the organic EL device 11 which are present in the inside of the passivation layer are physically protected. The layer can be any of resin, metal or a lamination of these.

The material for the applied layer is not limited to polysilazane, and can be for example, butyl gum having lower permeability to moisture and oxygen than the evaporated layer.

The organic EL device 1 can be used for a light source for other illumination devices and display devices, and is not limited to use for backlighting.

In the case of an organic EL device 11 for a display panel, for example, for use in a passive matrix display panel, the first electrode 13 is formed into a parallel striped shape on a surface of the glass substrate 12. The organic EL layer 14 is formed into a plurality of parallel stripes extending in a direction orthogonal to the first electrode 13 in a state insulated by insulative barriers not shown in the figures. The second electrode 15 is laminated on the organic EL layer 14. Pixels (pixels or subpixels) of the display panel are then formed by a matrix on the glass substrate at the intersecting portions of the first electrode 13 and the second electrode 15.

In the case where the organic EL device 11 is used for a display panel, a substrate on which a color filter is formed can be used for the substrate.

The substrate can be a transparent flexible substrate made of resin in place of the glass substrate 12.

The first electrode 13 disposed on the glass substrate 12 can be used as a cathode and the second electrode 15 can be used as an anode. In this case, the construction of the organic EL layer 14 is modified to be consistent with the anode and the cathode. For example, the organic EL layer 14 can be formed from a three-layer of electron injection layer, emitting layer and hole injection layer laminated in this order form the first electrode 13 side or formed from a five-layer of electron injection layer, electron transport layer, emitting layer, hole transport layer and hole injection layer.

The organic EL device is not limited to a bottom emission type in which light emitted from the organic EL layer 14 is extracted from the substrate, and it can also be a top emission type in which light is extracted from a side opposite to the substrate. In this case, the second electrode 15 disposed on the opposite side of the substrate by interposing the organic EL layer 14 need to be transparent. However, since the substrate need not be transparent, a metal substrate, opaque ceramic substrate or resin substrate and so forth can also be used instead of a glass substrate 12.

Therefore, the present examples and embodiments are to be considered as illustrative and not restrictive and the invention is not to be limited to the details given herein, but may be modified within the scope and equivalence of the appended claims.

An organic electroluminescence device comprising a subsrate, a first electrode, an organic electroluminescence layer and a second electrode laminated on the substrate in this order, and a passivation layer laminated on the outside of the second electrode. A film thickness t, which is a distance from a surface of the first electrode to the outer surface of the passivation layer in an area devoid of any foreign particle on a portion of the first electrode associated with the organic EL layer, is larger than the size of any foreign particle which is present on the first electrode.

## Claims

1. An organic electroluminescence device that is subjected to the presence of a foreign particle, the organic electroluminescence device including a substrate, a first electrode, an organic electroluminescence layer and a second electrode laminated on the substrate in this order, and a passivation layer laminated on the outer surface of the second electrode, in which a thickness t being the distance froma surface of the first electrode to the outer surface of the passivation layer in an area devoid of a foreign particle on a portion of the first electrode associated with the organic electroluminescence layer **characterized by** the thickness t being larger than the size of any foreign particle 17 present on the first electrode 13.

2. An organic electroluminescence device according to claim 1, **characterized by** the passivation layer 16 comprising a layer 16a formed by application.

3. An organic electroluminescence device according to claim 2 **characterized by** an evaporated layer 16b being formed inside of the layer 16a formed by application.

4. An organic electroluminescence device according to claim 2 or 3 **characterized by** the layer 16a formed by application comprising polysilazane.

5. An organic electroluminescence device according to any one of claims 1 to 3 **characterized by** a layer 18 adhered to the outer surface of the passivation layer 16.

6. A method for producing an organic electroluminescence device having a first electrode, an organic electroluminescence layer and a second electrode laminated in this order on a substrate, and a passivation layer laminated on the outside of the second electrode, including a step of cleaning a surface of the first electrode formed on the substrate, **characterized by** a step S2 of measuring the size of a foreign particle 17 present on the surface of the first electrode 13 after the cleaning step S1, and the steps forming the organic electroluminescence layer S3, forming the second electrode S4 and forming the passivation layer S5, if the size of the foreign particle 17 according to said measuring is less than a predetermined value as the total thicknesstofthelaterformedorganicelectroluminescencelayer 14, the second electrode 15 and the passivation layer 16.

7. A method for producing an organic electroluminescence device according to claim 6 **characterized by** the passivation layer 16 being formed by application.

8. A method for producing an organic electroluminescence device according to claim 6 **characterizedby** the step S5 of forming the passivation layer 16 being performed by forming the passivation layer 16 by evaporation, wherein the substrate is tilted within a range of 360 degrees along a micro virtual semi-sphere having a center on a straight line connecting a vapor source and a point on the substrate during the evaporation.

9. An organic electroluminescence device that is subject to the presence of a foreign particle, the organic electroluminescence device including a substrate, a first electrode formed on the substrate, an organic electroluminescence layer disposed on the first electrode, the first electrode sandwiched between the substrate and the organic electroluminescence layer, a second electrode disposed on the organic electroluminescence layer, the organic electroluminescence layer sandwiched between the first and second electrodes and a passivation layer disposed on the second electrode, the second electrode sandwiched between the organic electroluminescence layer and the passivation layer,
**characterized by** thickness of the passivation layer 16 combined with that of the second electrode 15 and the organic electroluminescence layer 14 is greater than the size of any foreign particle 17 present on the first electrode 13.

10. An organic electroluminescence device according to claim 9 **characterized by** the passivation layer 16 being formed by application.

11. An organic electroluminescence device according to claim 10 **characterized by** further comprising an evaporation layer 16b disposed between the second electrode 15 and the passivation layer 16.

12. An organic electroluminescence device according to any one of claims 9 to 11 **characterized by** the passivation layer 16 comprising polysilazane.

13. An organic electroluminescence device according to any one of claims 9 to 12 **characterized by** further comprising a layer 18 disposed on the passivation layer 16.

14. An organic electroluminescence device according to any one of claims 9 to 13 **characterized by** the passivation layer 16 comprising two different types of layers (16a, 16b).
